Europäisches Patentamt

European Patent Office

Office européen des brevets

(11) Publication number: **0 044 732**

**B1**

# EUROPEAN PATENT SPECIFICATION

(45) Date of publication of patent specification: **24.04.85**

(21) Application number: **81303301.6**

(22) Date of filing: **17.07.81**

(51) Int. Cl.⁴: **G 10 K 11/36, H 03 H 9/145**

(54) Acoustic surface wave transducer with improved inband frequency characteristics.

(30) Priority: **23.07.80 JP 99763/80**

(43) Date of publication of application:
**27.01.82 Bulletin 82/04**

(45) Publication of the grant of the patent:
**24.04.85 Bulletin 85/17**

(84) Designated Contracting States:
**DE FR GB**

(56) References cited:
**US-A-4 206 380**

IEEE ULTRASONICS SYMPOSIUM 1972, pages
413-416 New York, U.S.A. C.S. HARTMANN et
al.: "End effects in interdigital surface wave
transducers"

(73) Proprietor: **Oki Electric Industry Company,
Limited**
**7-12, Toranomon 1-chome Minato-ku
Tokyo 105 (JP)**

(73) Proprietor: **NIPPON HOSO KYOKAI**
**No- 2-1, Jinnan 2-chome Shibuya-ku
Tokyo (JP)**

(72) Inventor: **Chiba, Takao**
**c/o Nippon Hoso Kyokai Technical Research Lab
10-11, Kinuta 1-chome Setagaya-ku Tokyo (JP)**
Inventor: **Sakamoto, Nobuyoshi**
**c/o Oki Electric Industry Co.Ltd
7-12, Toranomon 1-chome Minato-ku Tokyo (JP)**
Inventor: **Kohro, Kenji**
**c/o Oki Electric Industry Co., Ltd
7-12, Toranomon 1-chome Minato-ku Tokyo (JP)**

(74) Representative: **George, Sidney Arthur et al**
**GILL JENNINGS & EVERY 53-64 Chancery Lane
London WC2A 1HN (GB)**

Courier Press, Leamington Spa, England.

## Description

This invention relates to an acoustic surface wave transducer, and in particular, relates to such a device with improved inband frequency characteristics. The present acoustic surface wave transducer is applicable to a mechanical bandpass filter, a delay line, a convolver, and/or a resonator, for use in the HF, VHF and/or UHF bands.

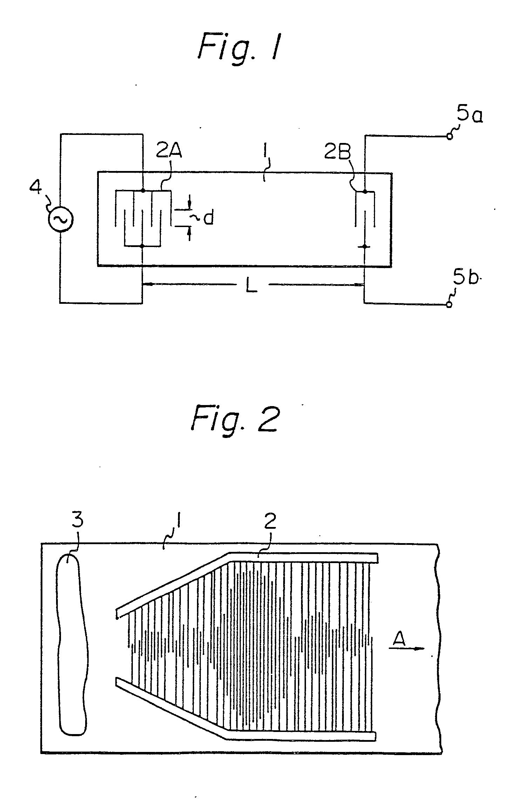

Fig. 1 of the accompanying drawings shows a basic structure of a prior acoustic surface wave device, in which a piezoelectric substrate 1 is made of, for instance, lithium niobate ($LiNbO_3$), $LiTaO_3$, or PZT. Interdigital electrode structures 2A and 2B are positioned on the surface of the substrate 1. Each structure comprises two electrodes which are interdigitated. A high-frequency power source 4 is coupled to the first interdigital electrode structure 2A, and output terminals 5a, 5b are coupled to the second interdigital electrode structure 2B. The electrode structures 2A and 2B are positioned with a predetermined spacing L, and each interdigital electrode structure is so arranged that the fingers of one electrode overlap the fingers of the other electrode by a distance d.

Upon application of a high-frequency signal to the first (transmission) interdigital electrode structure 2A, a mechanical vibration is induced in the substrate 1, and that vibration propagates in the substrate 1, in a direction perpendicular to the fingers, in the form of an acoustic surface wave. The second (reception) interdigital electrode structure 2B, located along the path of the acoustic surface wave, transduces the mechanical energy in the substrate 1 to electrical energy. Between the input and the output, signal processing is performed, so that the device acts as a delay line, a bandpass filter, an oscillator, a mixer and/or a convolver.

The width of each finger of an electrode, and the spacing between adjacent fingers, may be 1/4 wavelength, or 1/8 wavelength. Alternatively, a finger of 1/8 wavelength width and a finger of 5/8 wavelength width may be arranged alternately. The arrangement of 1/8 wavelength width fingers with a spacing of 1/8 wavelength is called a split-type electrode.

Many improvements of such an acoustic surface wave device have been proposed. US Patent No. 3 810 257 and US Patent No. 3 886 504 disclose some examples. The former discloses a transducer which reduces triple transit signals, and the latter discloses an improvement in the resonator devices.

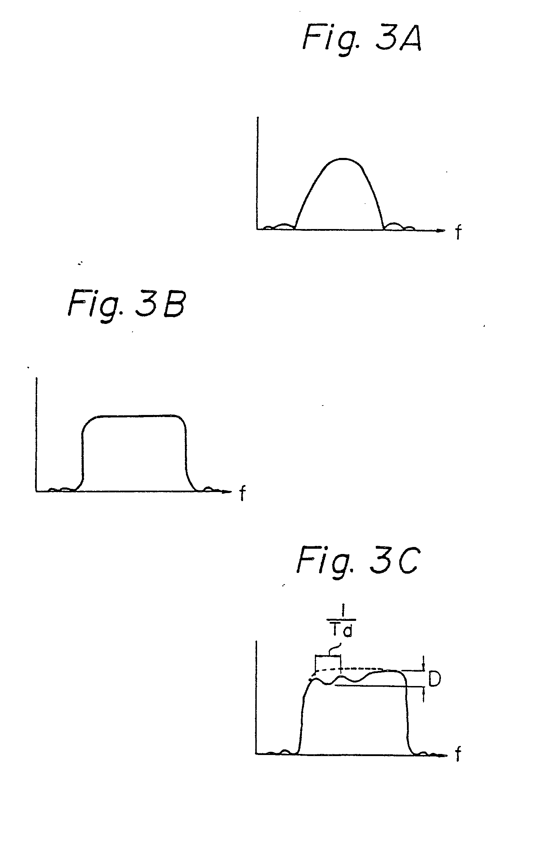

Fig. 2 shows another prior transducer, in which the overlap distance d between adjacent fingers is not constant, but depends upon the position of the fingers. A symbol A shows the direction of propagation of an acoustic surface wave. An interdigital electrode structure having a non-uniform overlap distance d is called an apodized electrode structure, whilst and interdigital electrode structure having a constant overlap distance is called a regular electrode structure. A bandpass filter using a regular interdigital electrode structure provides a single-hump frequency characteristic as shown in Fig. 3A, where the horizontal axis represents the frequency, and the vertical axis represents the response level. On the other hand, a bandpass filter with an apodized interdigital electrode structure provides a flat frequency characteristic as shown in Fig. 3B.

In the device of Fig. 2, the overlap distance between adjacent electrode fingers is long at the middle portion of the electrode structure, and is short at both of the end portions of the electrode structure. Hence, a strong acoustic wave is generated at the middle portion of the electrode structure, and a rather weak acoustic wave is generated at the end portions of the electrode structure. An apodized electrode structure is preferable for a bandpass filter which has the improved flat frequency characteristic as shown in Fig. 3B. A flat characteristic is important for a bandpass filter in a television transmission system, which requires a characteristic with leass than 0.2 dB deviation in the inband frequency response.

The prior transducer of Fig. 2 includes features for improving the characteristics of the filter. One such feature is the presence of an acoustical absorber 3, made of plastics material, near the end of the substrate 1 for preventing the effect of reflection of the wave at the end of the substrate. A second feature is the provision of a rough or uneven bottom surface of the substrate 1 for scattering acoustic waves directed towards the inside of the substrate, to eliminate the effect of internally-directed waves.

However, the prior acoustic wave transducers described above have the disadvantage that the amplitude characteristics and the group delay characteristics have a rather large inband deviation D as shown in Fig. 3C. When a bandpass filter is used in a television transmission apparatus, that inband deviation must be less than 0.2 dB in the amplitude characteristic, and less than 20 nS in the group delay characteristic. However, the prior bandpass filter has no better than 0.6 dB of inband deviation for the amplitude characteristic, and 60 nS from the group delay characteristic. Therefore, when the inband deviation characteristics must be extremely small, the prior acoustic wave filter cannot be utilised. Instead, an LC (inductance/capacitance) filter has been used for that purpose. However, an LC filter has the disadvantages that it is large, the precise adjustment of an inductance and/or a capacitance is necessary, and the phase characteristics deteriorate at the boundaries of the pass band and the attenuation bands.

It is an object of the present invention to provide a new and improved acoustic surface wave transducer.

According to the present invention, there is provided an acoustic surface wave transducer comprising a substrate at least a surface of which is piezo-electric; a first interdigital electrode structure disposed on the piezo-electric surface and comprising a pair of comb-like electrodes each comprising an arrangement of interconnected fingers and engaged interdigitally with each other, the first electrode structure being operable to convert an input electrical signal to acoustic surface waves which propagate in the piezo-electric surface; and a second interdigital electrode structure disposed in the piezo-electric surface and spaced from the first interdigital electrode structure by a predetermined distance, and comprising a pair of comb-like electrodes comprising an arrangement of interconnected fingers and engaged interdigitally with each other, the second electrode structure being effective to convert the acoustic surface waves in the piezo-electric surface to an output electrical signal; in which transducer an end of at least one of the electrode structures produces an undesired acoustic surface wave which propagates in the piezo-electric surface; characterised in that said end of the electrode structure is so constructed as to produce also a second undesired acoustic surface wave having essentially the same magnitude as the first undesired acoustic surface wave and a phase displacement relative thereto of 1/2 wavelength, whereby the two undesired acoustic surface waves cancel each other out.

Embodiments of the invention will now be described, by way of example, with reference to the accompanying drawings, in which:

Fig. 1 shows the basic structure of a prior acoustic surface wave transducer bandpass filter;

Fig. 2 shows another prior acoustic surface wave bandpass filter;

Figs. 3A, 3B and 3C show three typical characteristics of a bandpass filter;

Figs. 4A, 4B and 4C illustrate the edge effect of an acoustic surface wave transducer for explanation of the principle of the present invention;

Fig. 5A shows the basic construction of an interdigital electrode structure of a transducer according to the present invention;

Fig. 5B shows a practical interdigital electrode structure using the principle of Fig. 5A;

Fig. 6 shows another interdigital electrode structure of a transducer according to the present invention;

Fig. 7 shows a further interdigital electrode structure of a transducer according to the present invention;

Fig. 8 shows yet another interdigital electrode structure of a transducer according to the present invention;

Fig. 9A and Fig. 9B show further interdigital electrode structures of transducers according to the present invention; and

Figs. 10A, 10B, 10C and 10D show some bandpass filters using the present acoustic surface wave transducer.

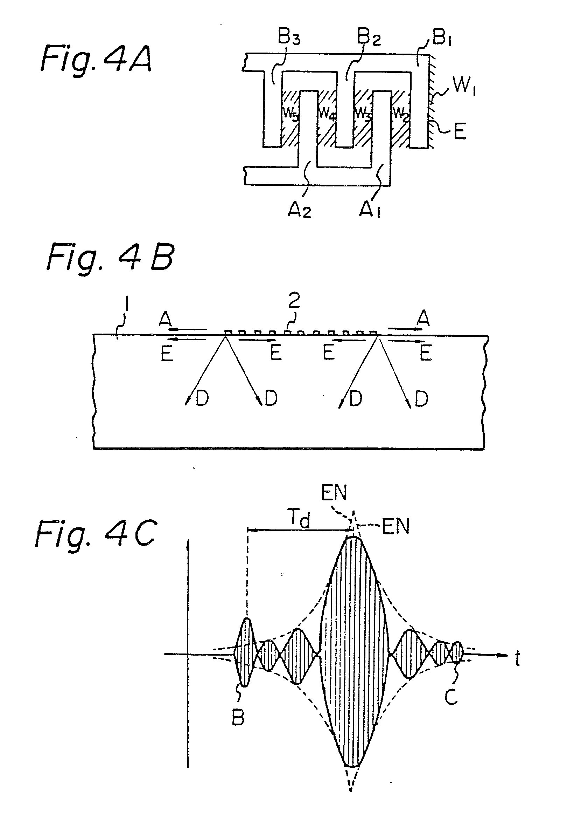

We have studied a prior bandpass filter using an acoustic surface wave transducer, and we have found that the edge effect of an interdigital electrode structure causes increase of the inband deviation of the amplitude characteristic and the group delay characteristic. The edge effect of an interdigital electrode structure is described first with reference to Figs. 4A, 4B and 4C.

Conventionally, it has been assumed that an acoustic surface wave is generated between adjacent fingers of a pair of interdigitated electrodes. Therefore, in Fig. 4A, when a first group of fingers $B_1$, $B_2$ and $B_3$, and a second group of fingers $A_1$ and $A_2$ are engaged, the acoustic surface wave has been assumed to be generated in an area $W_2$ between $A_1$ and $B_1$, an area $W_3$ between $A_1$ and $B_2$, an area $W_4$ between $A_2$ and $B_2$, and an area $W_5$ between $A_2$ and $B_3$. However, we have found that an acoustic surface wave is also generated at the external edge E of the extreme end finger $B_1$, or in the area $W_1$ contacting the edge E, even though there is no finger which faces the edge E. The generation of an acoustic surface wave at the external edge E of the extreme end finger, i.e. the edge effect, is confirmed as follows.

We observed an acoustic surface wave by using a laser holographic technique at the side wall of the substrate as shown in Fig. 4B, and found that there are generated not only a desired surface wave A, but also undesired waves E and D which are generated at the external edge of the extreme end finger. The undesired waves are not only a surface wave E, but also a bulk wave D which is directed into the substrate. The effect of the bulk wave D can be cancelled by a conventional uneven or rough bottom surface of the substrate. However, the undesired surface wave E degrades the characteristics of a filter. The wavelength of the undesired surface wave E is almost the same as the wavelength of the desired acoustic surface wave which is generated between two adjacent fingers. The wave E may be a Rayleigh wave, or a pseudo-acoustic surface wave, although the physical mechanism for the generation of the undesired wave is unknown.

The presence of the undesired surface wave E generated at the outer edge of the extreme end fingers is also confirmed by an impulse response of an interdigital electrode structure as described with reference to Fig. 4C. As is well known, the characteristic or the transfer function F of a filter is obtained from the pulse responses as follows:

$$F = H_1(\omega) \cdot H_2(\omega) \exp(j\omega L/v)$$

where F is a transfer function of the filter, $H_1(\omega)$ is a Fourier transform of an impulse response of a first (or transmission) interdigital electrode structure, $H_2(\omega)$ is a Fourier transform of an impulse response of a second (or reception) interdigital electrode structure, $(\omega)$ is an angular frequency, L is the distance between the transmission and reception electrode structures, and v is the sound velocity of the surface wave in the substrate. When an interdigital electrode structure is a regular interdigital electrode structure which has the same facing lengths for all of the fingers, the envelope EN of an impulse response is triangular. When the interdigital electrode is an apodized electrode structure, that envelope is somewhat curved. In Fig. 4C, the presence of spurious responses B and C, which are not wholly within the envelope EN, should be noted. The distance $T_d$ between the centres of the main response and the spurious response B implies the presence of the edge effect and the deterioration of the inband characteristics of a filter, since the period of the ripple of the inband characteristics is exactly the same as $1/T_d$.

Therefore, the basic concept of the present invention is to eliminate that edge effect, which gives rise to an undesired acoustic surface wave which is generated at the outer edge of the extreme end fingers, by providing edge-effect cancellation.

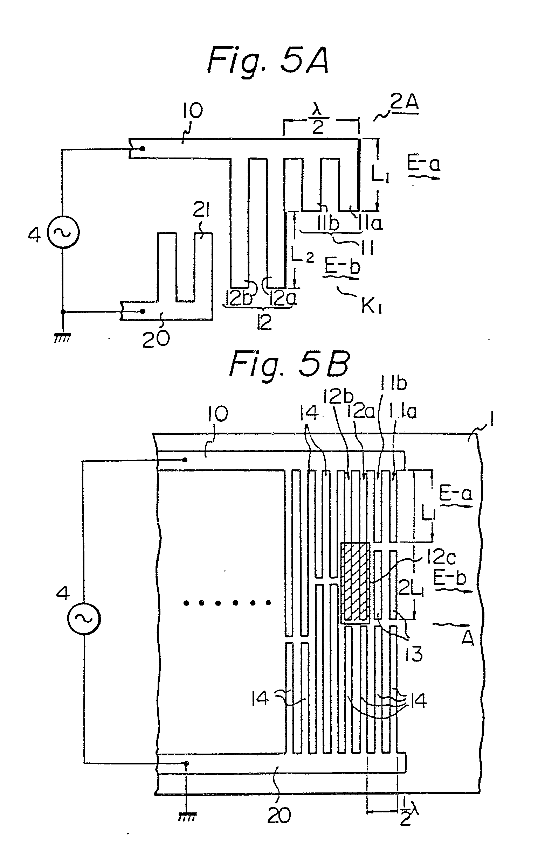

Figs. 5A and 5B show a first embodiment of the present transducer, in which a first comb-like electrode 10 comprises a plurality of fingers 11a, 11b, 12a, 12b. A second electrode 20 is grounded, and a source 4 applies an alternating signal between the first and second electrodes 10 and 20. Those electrodes are interdigitally engaged, as shown in the Figures, to form an interdigital electrode structure. Since the electrode 20 is grounded, it does not give rise to an edge effect, i.e. the extreme edge of the electrode 20 does not generate an undesired acoustic surface wave. Therefore, it is necessary only to prevent the edge effect of the first electrode 10.

In Fig. 5A, the first electrode 10 has two fingers 11 and 12 which are located outside the extreme end finger 21 of the second electrode. The fingers 11 and 12 are, in practice, preferably split into pairs of sub-fingers 11a, 11b and 12a, 12b, respectively, for a reason which will be explained later. The length $L_1$ of the extreme end finger 11, and the length $L_1 + L_2$ of the second extreme end finger 12 are designed so that $L_1 = L_2$. In other words, the length of the second extreme end finger 12 is twice as long as the extreme end finger 11. Furthermore, the spacing between the right hand edge (as viewed in Fig. 5A) of the finger 11 and the right hand edge of the finger 12 is designed to be 1/2 wavelength.

In that configuration, when the electrodes 10 and 20 are excited by the power source 4, the right hand edge of the finger 11 generates an undesired surface wave E-a along the length $L_1$, and the right hand edge of the finger 12 generates an undesired surface wave E-b along the length $L_2$. Those undesired surface waves E-a and E-b propagate along the surface of the substrate, towards a reception interdigital electrode structure (not shown).

It should be noted that the undesired surface wave E-a has the same strength as the undesired surface wave E-b, since the lengths $L_1$ and $L_2$ which generate the undesired surface waves are equal, and that the phase of the wave E-a is opposite to that of the wave E-b, since the right hand edges of the fingers 11 and 12 are spaced apart by 1/2 wavelength. Accordingly, the two undesired surface waves E-a and E-b are cancelled by each other, and those waves are not received by the reception interdigital electrode.

Hence, the edge effect is cancelled, and the inband deviation of a filter is improved. Therefore, the structure of Fig. 5A constitutes an edge-effect canceller $K_1$, or an undesired-wave canceller.

In Fig. 5A, the fingers 11 and 12 are split into sub-fingers 11a, 11b and 12a, 12b, respectively, as mentioned above. A split finger has the advantage that it can cancel the reflection of the surface wave due to the difference of the acoustic impedance between the substrate with an electrode conductor, and the substrate with no electrode conductor. In the case of a split finger, it should be appreciated that the width of each sub-finger, and the spacing between adjacent sub-fingers, is 1/8 wavelength. The present invention is applicable not only to split fingers, but also to ordinary fingers. In the latter case the width of each finger 11 and 12, and the spacing between the fingers, is 1/4 wavelength.

Fig. 5B shows the detailed structure of a transducer employing the same concept as Fig. 5A. The length $L_1$ of the extreme end finger 11 is half that of the second extreme end finger 12, and the spacing between the extreme right hand edges of the fingers 11 and 12 is 1/2 wavelength. Therefore, the undesired surface wave E-b generated at a portion 12c (shown hatched) of the finger 12 is cancelled by the undesired surface wave E-a generated by the finger 11.

The embodiment of Fig. 5B has dummy split fingers 14 which confront with the corresponding facing fingers of the opposite electrode, and a floating (i.e. unconnected) split finger 13 located between the extreme end finger 11 and the dummy finger 14 at the extreme end portion. The dummy finger and the floating finger do not generate an acoustic surface wave, but are provided just for the smooth transmission of the surface wave on the substrate which would otherwise be disturbed by the difference in sound velocity between the substrate covered with an electrode conductor and the substrate with no electrode conductor. The presence of the dummy fingers and the floating finger further improves the characteristics of the transducer.

The acoustic surface wave transducer of Figs. 5A and 5B may have a plastics acoustical absorbent as shown in Fig. 2, and the bottom of the substrate may be rough or uneven to scatter a bulk wave as described with reference to Fig. 4B.

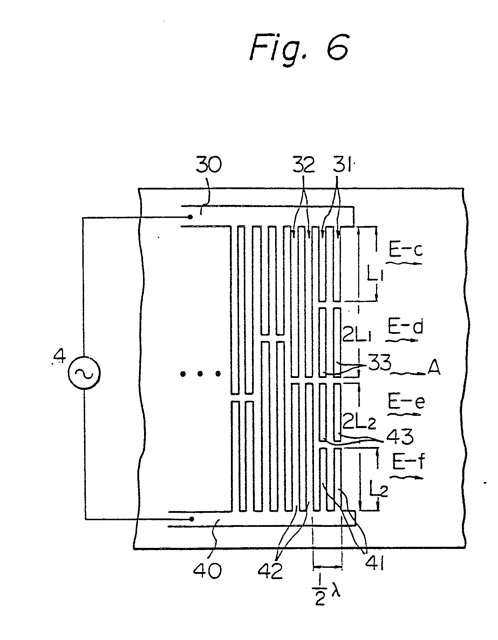

Fig. 6 shows another transducer according to the present invention, in which a pair of interdigital electrodes 30 and 40 are excited by a balanced-type power source 4. That is to say, neither electrode is grounded. In the embodiment of Fig. 6, both of the electrodes 30 and 40 have a structure for preventing edge effect. Again, each finger is divided into a pair of sub-fingers. The length $L_1$ of the extreme end finger 31 of the electrode 30 is half the length of the second extreme end finger 32, and the length $L_2$ of the extreme end finger 41 of the electrode 40 is half the length of the second extreme end finger 42. The spacing between the right hand edges of the fingers 31 and 32, and the spacing between the right hand edges of the fingers 41 and 42, is 1/2 wavelength. In the above configuration, an undesired surface wave E-c generated by the right hand edge of the finger 31 is cancelled by an undesired surface wave E-d generated by the right hand edge of the finger 32, so that these waves have no effect on the reception electrode. Similarly, an undesired surface wave E-e generated by the right hand edge of the top half portion of the finger 42 is cancelled by an undesired surface wave E-f generated by the right hand edge of the finger 41. In Fig. 6, fingers 33 and 43 are floating fingers.

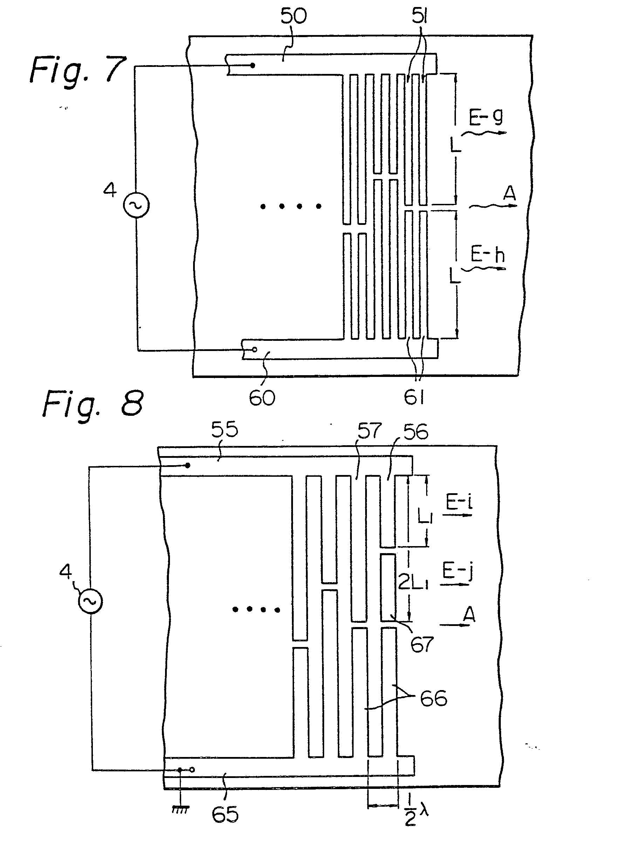

Fig. 7 shows another embodiment of the present invention, in which a pair of interdigital electrodes 50 and 60 are excited by a balanced power source 4, and neither electrode is grounded. In the embodiment of Fig. 7, the length L of the extreme end finger 51 of the first electrode 50 is the same as the length L of the extreme end finger 61 of the second electrode 60. Since the electrodes 50 and 60 are excited by the balanced power source, an undesired surface wave E-g generated by the right hand edge of the finger 51 has a phase which is opposite to that of the undesired surface wave E-h generated by the right hand edge of the finger 61. Hence, by making the lengths of the fingers 51 and 61 equal to each other, those two undesired surface waves cancel each other as far as the reception electrode structure is concerned.

Fig. 8 shows the structure of another transducer according to the present invention, in which electrodes 55 and 65 with fingers of 1/4 wavelength width are utilised, whereas the previous embodiments of Figs. 5A, 5B, 6 and 7 use electrodes with split fingers 1/8 wavelength wide. The electrodes are excited by an unbalanced power source 4, and the electroce 65 is grounded. In Fig. 8, the length $L_1$ of a finger 56 at the extreme end of the electrode 55 is half the length of the adjacent finger 57 of the electrode 55, and the spacing between the right hand edges of the fingers 56 and 57 is 1/2 wavelength. Therefore, an undesired surface wave E-i generated by the right hand edge of the finger 56 is cancelled by an undesired wave E-j generated by the right hand edge of the finger 57. Dummy fingers 66 and a floating finger 67 are provided.

It should be appreciated that the modification of electrodes having 1/4 wavelength fingers to suit a balanced power source will be understandable to those skilled in the art. Thus, an electrode structure of 1/4 wavelength fingers with two undesired wave cancellers as shown in Fig. 6 is possible, and an electrode structure of 1/4 wavelength fingers with a pair of extreme end fingers of equal lengths as shown in Fig. 7 is possible.

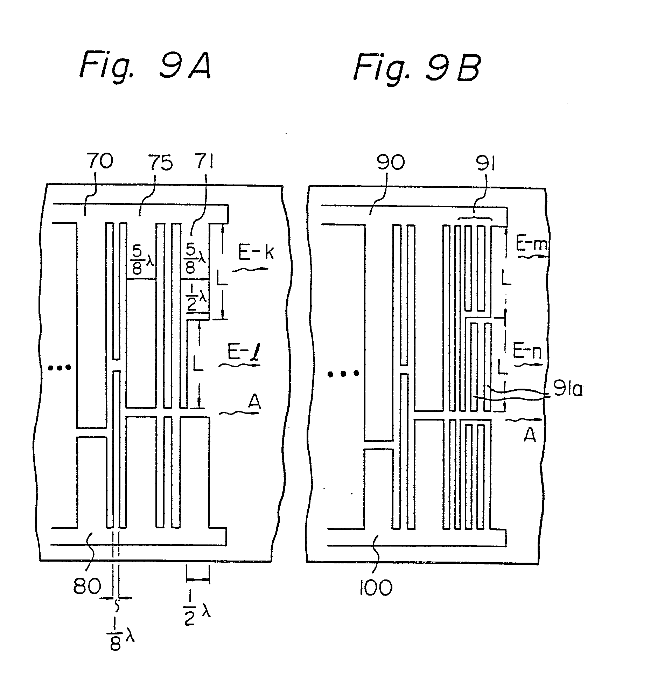

Fig. 9A shows another structure of the present transducer, in which each electrode 70 and 80 has fingers of 1/8 wavelength width and fingers of 5/8 wavelength width. It is assumed that the electrodes 70 and 80 are excited by an unbalanced power source and that the electrode 80 is grounded. Therefore, the electrode 70 has an undesired-wave canceller, and the electrode 80 has no undesired-wave canceller. In Fig. 9A, the extreme end finger 71 of the electrode 70 has a width of 5/8 wavelength at a root portion which is coupled to a common arm 75 of the electrode 70, and has a width of 1/8 wavelength at its other end. The length L of the portion with the 1/8 wavelength width is the same as the length L of the portion with the 5/8 wavelength width. The spacing between the right-hand edge of the 5/8 wavelength width portion and the right-hand edge of the 1/8 wavelength width portion is, of course, 1/2 wavelength. Accordingly, an undesired surface wave E-k generated at the right-hand edge of the 5/8 wavelength width portion of the finger 71 has a phase difference of 1/2 wavelength relative to an undesired surface wave E-l generated at the right hand edge of the 1/8 wavelength width portion of the finger 71. Hence, those undesired surface waves cancel each other.

Fig. 9B shows a modification of the embodiment of Fig. 9A. The distinguishing features of the embodiment of Fig. 9B are the presence of a split floating electrode 91a, and the division of the extreme end finger 91 of the electrode 90 into three sub-fingers as shown in the Figure. Due to the presence of the floating electrode 91a, the ratio of the length of the substrate covered with the electrode conductor to the total length of the substrate in the direction of transmission of the wave becomes almost equal for all of the paths, and the sound velocity of the surface wave therefore becomes substantially equal for all the paths. Accordingly, the wave front of the acoustic surface wave generated by the interdigital electrode structure is not impaired, and an excellent transducer or a bandpass filter is obtained.

It will be understandable to those skilled in the art how to adapt the embodiment having electrodes with 1/8 wavelength width fingers and 5/8 wavelength width fingers to suit the balanced power source of Fig. 6 or Fig. 7.

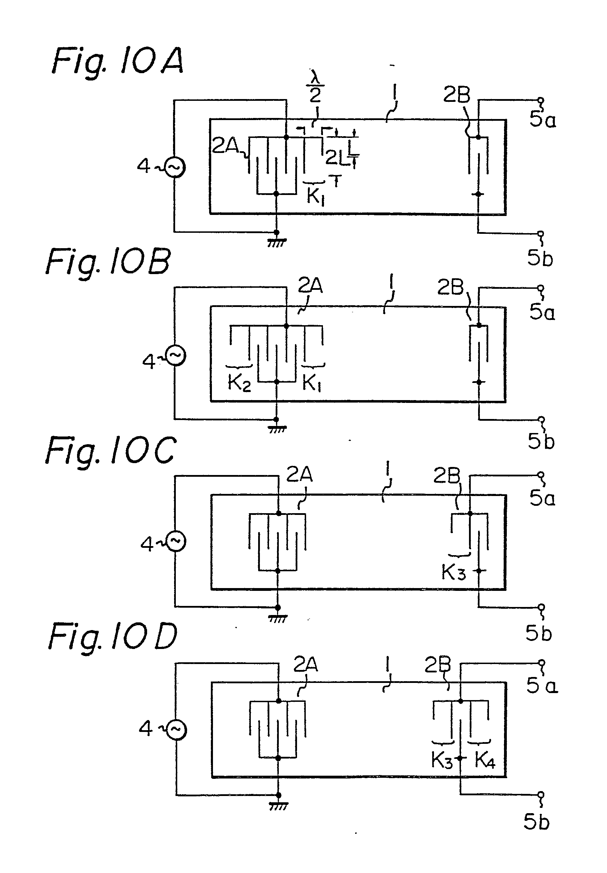

Figs. 10A to 10D show some applications of the present undesired-wave canceller to a bandpass filter. As previously, there are provided a piezoelectric substrate 1, a transmission interdigital electrode structure 2A, a reception interdigital electrode structure 2B, a power source 4, and output terminals 5a and 5b.

The embodiment of Fig. 10A has an undesired-wave canceller $K_1$ on the transmission interdigital electrode structure at the side nearer to the reception interdigital electrode structure. The length of the extreme end finger is half that of the second finger from the end, and the spacing between those two fingers is 1/2 wavelength.

In the Fig. 10B embodiment, undesired-wave-cancellers $K_1$ and $K_2$ are provided on opposite sides of the transmission interdigital electrode structure 2A. By use of this configuration the characteristics of the transducer are further improved.

In the Fig. 10C embodiment, an undesired-wave canceller $K_3$ is provided at the reception interdigital electrode structure 2B at the side nearer to the transmission interdigital electrode structure 2A. The effect of the Fig. 10C configuration is almost the same as that of Fig. 10A.

In the Fig. 10D embodiment, undesired-wave cancellers $K_3$ and $K_4$ are provided at opposite sides of the reception interdigital electrode structure 2B. The effect of the Fig. 10D configuration is almost the same as that of Fig. 10B.

Finally, constructional details of a bandpass filter utilising the present undesired-wave canceller are described. For a bandpass filter for use in the 20 MHz band, the preferred substrate is of lithium-niobate ($LiNbO_3$) with surface dimensions of 14 mm × 23 mm and a thickness of 1 mm. The transmission interdigital electrode structure is an apodized electrode structure having 60 pairs of split fingers each having a width of 1/8 wavelength, and the reception interdigital electrode structure is a regular electrode structure having 5 pairs of split fingers each having a width of 1/8 wavelength. The electrodes are made of gold, plated on the niobate substrate by a conventional photoligthographic process. The inband deviation of the above bandpass filter is less than 0.2 dB for the amplitude characteristic, and less than 20 nano-second for the group delay characteristic. The best characteristics obtained from a conventional bandpass filter have been 0.6 dB and 60 nano-second, respectively. Hence, the deviation of the present filter is improved by a factor of three as compared with a conventional filter.

As described above in detail, the present invention cancels the edge effect of an interdigital electrode structure in an acoustic surface wave transducer device by using, in one or each of the electrodes forming the structure, a pair of fingers, or parts of a finger, with their corresponding edges spaced by 1/2 wavelength, or by aligning the end fingers of the electrodes, making those fingers of equal lengths and feeding a balanced signal to the electrodes. Thus, the undesired surface wave generated at the edge of the extreme end finger is cancelled, and the characteristics of an acoustic surface wave device are thereby improved. The present invention is applicable to all kinds of acoustic surface wave devices and, in particular, the inband deviation of a bandpass filter is improved.

## Claims

1. An acoustic surface wave transducer comprising a substrate (1) at least a surface of which is piezo-electric; a first interdigital electrode structure (2A) disposed on the piezo-electric surface and comprising a pair of comb-like electrodes (10, 20; 30, 40; 50, 60; 55, 65; 75, 80; 90, 100) each comprising an arrangement of interconnected fingers and engaged interdigitally with each other, the first electrode structure being operable to convert an input electrical signal to acoustic surface waves which propagate in the piezo-electric surface; and a second interdigital electrode structure (2B) disposed on the piezo-electric surface and spaced from the first interdigital electrode structure (2A) by a predetermined distance, and comprising a pair of comb-like electrodes each comprising an arrangement of interconnected fingers and engaged interdigitally with each other, the second electrode structure being effective to convert the acoustic surface waves in the piezo-electric surface to an output electrical signal; in which transducer an end of at least one of the electrode structures produces an undesired acoustic surface wave (E-a) which propagates in the piezo-electric surface; characterised in that said end of the electrode structure (2A, 2B) is so constructed as to produce also a second undesired acoustic surface wave (E-b) having essentially the same magnitude as the first undesired acoustic surface wave and a phase displacement relative thereto of 1/2 wavelength, whereby the two undesired acoustic surface waves cancel each other out.

2. A transducer according to claim 1, characterised in that said first undesired acoustic surface wave (E-a) is generated by an outside edge of the extreme end finger (11) of one of the electrodes (10); in that the extreme end finger is made half the length of the second extreme end finger (12); and in that the spacing between said edge of the extreme end finger and the corresponding edge of the second extreme end finger is made equal to 1/2 wavelength of the acoustic surface waves, whereby the second undesired acoustic surface wave is produced by the portion ($L_2$) of the second extreme end finger (12) which projects beyond the end of the extreme end finger, there being no part of the other electrode (20) above or in the path of the second undesired acoustic surface wave extending away from said electrode structure.

3. A transducer according to claim 2, characterised in that the width of each finger (56, 57), and the spacing between adjacent fingers, is 1/4 wavelength.

4. A transducer according to claim 2, characterised in that each finger is split into a pair of sub-fingers, and the width of each sub-finger (11a, 11b, 12a, 12b) and the spacing between adjacent sub-fingers, is 1/8 wavelength.

5. A transducer according to claim 2 or claim 3, wherein a first undesired acoustic surface wave (E-c, E-f) is also generated by the edge of the corresponding extreme end finger (31, 41) of the other electrode (30, 40) characterised in that both extreme end fingers (31, 41) are made half the length of the corresponding second extreme end finger (32, 42); and in that the spacing between said edge of each extreme end finger and the corresponding edge of the second extreme end finger is made equal to 1/2 wavelength of the acoustic surface waves, whereby a respective second undesired acoustic surface wave is produced by the portion of each second extreme end finger (32, 42) which projects beyond the end of the corresponding extreme end finger (31, 41), there being no part of the other electrode (40, 30) in the path of the second undesired acoustic surface wave produced by either electrode (30, 40) extending away from said electrode structure.

6. A transducer according to claim 1, characterised in that each electrode (70, 80) comprises an arrangement of fingers of 1/8 wavelength width and fingers (75) of 5/8 wavelength width alternately, the spacing between adjacent fingers being 1/8 wavelength; and in that said first undesired acoustic surface (E-k) is generated by an edge of a first part of the extreme end finger (71) of one of the electrodes (70); and in that said extreme end finger is formed with said first part of width 5/8 wavelength and a second part of width 1/8 wavelength stepped back from said edge by 1/2 wavelength, the two parts being of equal lengths, whereby the second undesired acoustic surface wave (E-l) is produced by the extreme edge of said second part, there being no part of the other electrode (80) in the path of the second undesired acoustic surface wave.

7. A transducer according to claim 6, characterised in that said first part of the extreme end finger is formed as three portions each of 1/8 wavelength width, spaced apart by 1/8 wavelength.

8. A transducer according to any one of claims 2—7, characterised in that at least one electrically-floating finger (13; 33; 43; 67; 91a) is provided in a gap between opposing ends of the extreme end fingers of the electrodes (11, 14; 30, 40; 55, 65; 70, 80).

9. A transducer according to claim 1, for use with a balanced source of said input electrical signals, characterised in that said first undesired acoustic surface wave (E-g) is generated by an outside edge of the extreme end finger (51) of one of the electrodes (50); and in that said second undesired acoustic surface wave (E-h) is produced by the corresponding extreme end finger (61) of the other electrode (60) which is aligned end-to-end with the extreme end finger (51) of the first-mentioned electrode with a small gap therebetween and is made equal in length to said extreme end finger of the first-mentioned electrode.

10. A transducer according to any preceding claim, characterised in that cancellation of said undesired acoustic surface wave is effected at that one end ($K_1$) of the first interdigital electrode structure (2A) which is closer to the second interdigital electrode structure (2B).

11. A transducer according to any one of claims 1—9, characterised in that cancellation of said first undesired acoustic surface wave is effected at both ends ($K_1$, $K_2$) of the first interdigital electrode structure (2A).

12. A transducer according to any one of claims 1—9, characterised in that cancellation of said first undesired acoustic surface wave is effected at that one end ($K_3$) of the second interdigital electrode structure (2B) which is closer to the first interdigital electrode structure (2A).

13. A transducer according to any one of claims 1—9, characterised in that cancellation of said first undesired acoustic surface wave is effected at both ends ($K_3$, $K_4$) of the second interdigital electrode structure (2B).

## Patentansprüche

1. Akustischer Oberflächerwellenwandler mit einer Unterlage (1), von der wenigstens eine Oberfläche piezoelektrisch ist; einer ersten interdigitalen Elektrodenanordnung (2A) auf der piezoelektrischen Oberfläche mit einem Paar kammartiger Elektroden (10, 20; 30, 40; 50, 60; 55, 65; 75, 80; 90, 100), die jeweils eine Anordnung miteinander verbundener Finger aufweisen und interdigital ineinandergreifen, wobei die erste Elektrodenanordnung derart betreibbar ist, daß sie ein elektrisches Eingangssignal in akustische Oberflächenwellen umformt, die sich in der piezoelektrischen Oberfläche fortpflanzen; und einer zweiten interdigitalen Elektrodenanordnung (2B), die auf der piezoelektrischen Oberfläche in einem vorbestimmten Abstand von der ersten interdigitalen Elektrodenanordnung (2A) angeordnet ist und ein Paar kammartiger Elektroden aufweist, die jeweils eine Anordnung miteinander verbundener Finger aufweisen und interdigital ineinandergreifen, wobei die zweite Elektrodenanordnung bewirkt, daß die akustischen Oberflächenwellen in der piezoelektrischen Oberfläche in ein elektrisches Ausgangssignal umgeformt werden; und wobei bei diesem Wandler ein Ende wenigstens einer der Elektrodenanordnungen eine unerwünschte akustische Oberflächenwelle (E-a) erzeugt, die sich in der piezoelektrischen Oberflächen fortpflanzt, dadurch gekennzeichnet, daß das erwähnte Ende der Elektrodenanordnung (2A, 2B) so ausgebildet ist, daß es auch eine zweite unerwünschte akustische Oberflächenwelle (E-b) mit im wesentlichen der gleichen Größe wie die der ersten unerwünschten akustischen Oberflächenwelle und einer Phasenverschiebung relativ zu dieser von 1/2 Wellelänge erzeugt, so daß die beiden unerwünschten akustischen Oberflächenwellen einander auslöschen.

2. Wandler nach Anspruch 1, dadurch gekennzeichnet, daß die erwähnte erste unerwünschte akustische Oberflächenwelle (E-a) durch einen äußeren Rand des Extremalendefingers (11) der einen der Elektroden (10) erzeugt wird; daß der Extremalendefinger halb so lang wie der zweite Extremalendefinger (12) ist und daß der Abstand des erwähnten Randes des Extremalendefingers von dem entsprechenden Rand des zweiten Extremalendefingers gleich 1/2 Wellenlänge der akustischen Oberflächenwellen gewählt ist, so daß die zweite unerwünschte akustische Oberflächenwelle durch denjenigen Teil ($L_2$) des zweiten Extremalendefingers (12) erzeugt wird, der über das Ende des Extremalendefingers hinausragt, wobei kein Teil der anderen Elektrode (20) über oder in der Bahn der zweiten unerwünschten akustischen Oberflächenwelle liegt, die sich von der erwähnten Elektrodenanordnung weg erstreckt.

3. Wandler nach Anspruch 2, dadurch gekennzeichnet, daß die Breite jedes Fingers (56, 57) und der Abstand benachbarter Finger 1/4 Wellenlänge betragen.

4. Wandler nach Anspruch 2, dadurch gekennzeichnet, daß jeder Finger durch einen Schlitz in ein Paar Teilfinger unterteilt ist und die Breite jedes Teilfingers (11a, 11b, 12a, 12b) und der Abstand benachbarter Teilfinger 1/8 Wellenlänge betragen.

5. Wandler nach Anspruch 2 oder 3, bei dem die erste unerwünschte akustische Oberflächenwelle (E-c, E-f) auch durch den Rand des entsprechenden Extremalendefingers (31, 41) der anderen Elektrode (30, 40) erzeugt wird, dadurch gekennzeichnet, daß beide Extremalendefinger (31, 41) halb so lang wie der entsprechende zweite Extremalendefinger (32, 42) sind und daß der Abstand des erwähnten Randes jedes Extremalendefingers von dem entsprechenden Rand des zweiten Extremalendefingers gleich 1/2 Wellenlänge der akustischen Oberflächenwellen gewählt ist, so daß durch denjenigen Teil jedes zweiten Extremalendefingers (32, 42), der über das Ende des entsprechenden Extremalendefingers (31, 41), hinausragt, jeweils eine zweite unerwünschte akustische Oberflächenwelle erzeugt wird, wobei kein Teil der anderen Elektrode (40, 30) in der Bahn der zweiten unerwünschten akustischen Oberflächenwelle liegt, die durch die eine oder die andere der sich von der Elektrodenanordnung weg erstreckenden Elektroden (30, 40) erzeugt wird.

6. Wandler nach Anspruch 1, dadurch gekennzeichnet, daß jede Elektrode (70, 80) eine Anordnung von Fingern mit einer Breite von 1/8 Wellenlänge und Fingern (75) mit einer Breite von 5/8 Wellenlänge abwechselnd aufweist, wobei der Abstand benachbarter Finger 1/8 Wellenlänge beträgt; und daß die erwähnte erste unerwünschte akustische Oberflächenwelle (E-c) durch einen Rand eines ersten Teils des Extremalendefingers (71) einer der Elektroden (70) ezeugt wird; und daß der erwähnte Extremalendefinger mit dem erwähnten ersten Teil mit der Breite von 5/8 Wellenlänge und einem zweiten Teil mit der Breite von 1/8 Wellenlänge, der gegenüber dem erwähnten Rand um 1/2 Wellenlänge zurückversetzt ist, versehen ist, wobei die beiden Teile gleichlang sind, so daß die zweite unerwünschte akustische Oberflächenwelle (E-l) durch den äußersten Rand des erwähnten zweiten Teils erzeugt wird, wobei kein Teil der anderen Elektrode (80) in der Bahn der zweiten unerwünschten akustischen Oberflächenwelle liegt.

7. Wandler nach Anspruch 6, dadurch gekennzeichnet, daß der erwähnte erste Teil des Extremalendefingers aus drei Teilen mit jeweils einer Breite von 1/8 Wellenlänge und einem Abstand von 1/8 Wellenlänge gebildet ist.

8. Wandler nach einem der vorhergehenden Ansprüche 2 bis 7, dadurch gekennzeichnet, daß mindestens ein elektrisch potentialfreier Finger (13; 33; 43; 67; 91a) in einem Spalt zwischen sich gegenüberliegenden Enden der Extremalendefinger der Elektroden (11, 14; 30, 40; 55, 65; 70, 80) liegt.

9. Wandler nach Anspruch 1 zur Verwendung bei einer symmetrischen Quelle der erwähnten elektrischen Eingangssignale, dadurch gekennzeichne*, daß die erwähnte erste unerwünschte akustische Oberflächenwelle (E-g) durch einen äußeren Rand des Extremalendefingers (51) einer der Elektroden (50) erzeugt wird und daß die erwähnte zweite unerwünschte akustische Oberflächenwelle (E-h) durch den entsprechenden Extremalendefinger (61) der anderen Elektrode (60) erzeugt wird, der geradlinig mit dem Extremalendefinger (51) der zuerst erwähnten Elektrode ausgerichtet ist, so daß ihre Enden einander zugekehrt sind und einen kleinen Spalt zwischen sich aufweisen, und dessen Länge gleich der des erwähnten Extremalendefingers der zuerst erwähnten Elektrode ist.

10. Wandler nach einem vorhergehenden Anspruch, dadurch gekennzeichnet, daß die Auslöschung der erwähnten ersten unerwünschten akustischen Oberflächenwelle an demjenigen Ende ($K_1$) der ersten interdigitalen Elektrodenanordnung (2A) bewirkt wird, das näher bei der zweiten interdigitalen Elektrodenanordnung (2B) liegt.

11. Wandler nach einem der Ansprüche 1 bis 9, dadurch gekennzeichnet, daß die Auslöschung der erwähnten ersten unerwünschten akustischen Oberflächenwelle an beiden Ende ($K_1$, $K_2$) der ersten interdigitalen Elektrodenanordnung (2A) bewirkt wird.

12. Wandler nach einem der Ansprüche 1 bis 9, dadurch gekennzeichnet, daß die Auslöschung der erwähnten ersten unerwünschten akustischen Oberflächenwelle an demjenigen Ende ($K_3$) der zweiten interdigitalen Elektrodenanordnung (2B) bewirkt wird, das näher bei der ersten interdigitalen Elektrodenanordnung (2A) liegt.

13. Wandler nach einem der Ansprüche 1 bis 9, dadurch gekennzeichnet, daß die Auslöschung der erwähnten ersten unerwünschten akustischen Oberflächenwelle an beiden Ende ($K_3$, $K_4$) der zweiten interdigitalen Elektrodenanordnung (2B) bewirkt wird.

**Revendications**

1. Transducteur d'ondes acoustiques de surface comprenant un substrat (1) dont au moins une surface est piézoélectrique; une première structure d'électrodes interdigitales (2A) disposée sur la surface piézoélectrique et comprenant deux électrodes en forme de peigne (10, 20; 30, 40; 50, 60; 55, 65; 75, 80; 90, 100) constituant chacune une disposition de doigts interconnectés et engagés entre eux d'une manière interdigitale, la première structure d'électrode pouvant être mise en fonctionnement pour convertir un signal électrique d'entrée en ondes acoustiques de surface qui se propagent dans la surface piézoélectrique, et une seconde structure d'électrodes interdigitales (2B) disposée sur la surface piézoélectrique et espacée de la première structure d'électrodes interdigitales (2A) d'une distance prédéterminée, et comprenant deux électrodes en forme de peigne constituant chacune une disposition de doigts interconnectés et engagés entre eux d'une manière interdigitale, la seconde structure d'électrodes étant efficace pour convertir les ondes acoustiques de surface dans la surface piézoélectrique en un signal électrique de sortie; une extrémité d'au moins une des structures d'électrodes, dans le transducteur, produisant une onde acoustique de surface non voulue (E-a) qui se propage dans la surface piézoélectrique; caractérisé en ce que ladite extrémité de la structure d'électrodes (2A, 2B) est construite de manière à produire également une seconde onde acoustique de surface non voulue (E-b) ayant essentiellement la même grandeur que la première onde acoustique de surface non voulue et un déphasage par rapport à celui-ci de 1/2 de longueur d'onde, les deux ondes acoustiques de surface non voulues d'annulant ainsi.

2. Transducteur selon la revendication 1, caractérisé en ce que ladite première onde acoustique de surface non voulue (E-a) est engendrée par un bord extérieur du doigt d'extrémité extrême (11) d'une des électrodes (10); en ce que le doigt d'extrémité extrême a une longueur qui est la moitié de celle du second doigt d'extrémité extrême (12); et en ce que la distance entre le bord du doigt d'extrémité extrême et le bord correspondant du second doigt d'extrémité extrême est rendue égale à 1/2 de longueur d'onde des ondes acoustiques de surface, la seconde onde acoustique de surface non voulue étant ainsi produite par la partie (L₂) du second doigt d'extrémité extrême (12) qui s'étend au-delà de l'extrémité du doigt d'extrémité extrême, aucune partie de l'autre électrode (20) ne se trouvant au-dessus ou sur le trajet de la seconde onde acoustique de surface non voulue s'étendant loin de la structure d'électrodes.

3. Transducteur selon la revendication 2, caractérisé en ce que la largeur de chaque doigt (56, 57) et la distance entre des doigts voisins sont égales à 1/4 de longueur d'onde.

4. Transducteur selon la revendication 2, caractérisé en ce que chaque doigt est divisé en deux sous-doigts, et en ce que la largeur de chaque sous-doigt (11a, 11b, 12a, 12b) et la distance entre des sous-doigts voisins sont égales à 1/8 de longueur d'onde.

5. Transducteur selon l'une quelconque des revendications 2 et 3, caractérisé en ce que, une première onde acoustique de surface non voulue (E-c, E-f) étant également engendrée par le bord du doigt d'extrémité extrême correspondant (31, 41) de l'autre électrode (30, 40), les deux doigts d'extrémité extrêmes (31, 41) ont des longueurs qui sont la moitié de la longueur du second doigt d'extrémité extrême correspondant (32, 42); et en ce que la distance entre le bord de chaque doigt d'extrémité extrême et le bord correspondant du second doigt d'extrémité extrême est rendue égale à 1/2 de longueur d'onde des ondes acoustiques de surface, une seconde onde acoustique de surface non voulue respective étant ainsi produite par la partie de chaque second doigt d'extrémité extrême (32, 42) qui s'étend au-delà de l'extrémité du doigt d'extrémité extrême correspondant (31, 41), aucune partie de l'autre électrode (40, 30) ne se trouvant sur le trajet de la seconde onde acoustique de surface non voulue produite par l'électrode (30, 40) s'étendant loin de la structure d'électrodes.

6. Transducteur selon la revendication 1, caractérisé en ce que chaque électrode (70, 80) constitue une disposition de doigts de 1/8 de longueur d'onde de largeur et de doigts (75) de 5/8 de longueur d'onde de largeur, alternativement, la distance entre des doigts voisins étant de 1/8 de longueur d'onde; et en ce que la première onde acoustique de surface non voulue (E-k) est engendrée par un bord d'une première partie du doigt d'extrémité extrême (71) d'une des électrodes (70); et en ce que le doigt d'extrémité extrême est constitué d'une première partie de 5/8 de longueur d'onde de largeur et d'une seconde partie de 1/8 de longueur d'onde de largeur en retrait du bord de 1/2 de longueur d'onde, les deux parties ayant des longueurs égales, la seconde onde acoustique de surface non voulue (E-l) étant ainsi produite par le bord extrême de la seconde partie, aucune partie de l'autre électrode (80) ne se trouvant sur le trajet de la seconde onde acoustique de surface non voulue.

7. Transducteur selon la revendication 6, caractérisé en ce que ladite première partie du doigt d'extrémité extrême est constitué comme trois parties ayant chacune une largeur de 1/8 de longueur d'onde et étant espacées entre elles de 1/8 de longueur d'onde.

8. Transducteur selon l'une quelconque des revendications 2 à 7, caractérisé en ce qu'au moins un doigt flottant électriquement (13; 33; 43; 67; 91a) est prévu dans un espace situé entre les extrémités opposées des doigts d'extrémité extrêmes des électrodes (11, 14; 30, 40; 55, 65; 70, 80).

9. Transducteur selon la revendication 1 utilisable avec une source équilibrée de signaux électriques d'entrée, caractérisé en ce que la première onde acoustique de surface non voulue (E-g) est engendrée par un bord extérieur du doigt d'extrémité extrême (51) d'une des électrodes (50); et en ce que la seconde onde acoustique de surface non voulue (E-h) est produite par le doigt d'extrémité extrême correspondant (61) de l'autre électrode (60) qui est aligné bout-à-bout avec le doigt d'extrémité extrême (51) de la première électrode mentionée avec un petit espace entre elles et dont la longueur est rendue égale à celle du doigt d'extrémité extrême de ladite première électrode.

10. Transducteur selon l'une quelconque des revendications 1 à 9, caractérisé en ce que l'annulation de la première onde acoustique de surface non voulue est effectuée à l'extrémité (K₁) de la première structure d'électrodes interdigitales (2A) qui est plus près de la seconde structure d'électrodes interdigitales (2B).

11. Transducteur selon l'une quelconque des revendications 1 à 9, caractérisé en ce que l'annulation de la première onde acoustique de surface non voulue est effectuée aux deux extrémités ($K_1$, $K_2$) de la premirère structure d'électrodes interdigitales (2A).

12. Transducteur selon l'une quelconque des revendications 1 à 9, caractérisé en ce que l'annulation de la première onde acoustique de surface non voulue est effectuée à l'extrémité ($K_3$) de la seconde structure d'électrodes interdigitales (2B) qui est plus près de la première structure d'électrodes interdigitales (2A).

13. Transducteur selon l'une quelconque des revendications 1 à 9, caractérisé en ce que l'annulation de la première onde acoustique de surface non voulue est effectuée aux deux extrémités ($K_3$, $K_4$) de la seconde structure d'électrodes interdigitales (2B).

*Fig. 1*

*Fig. 2*

# Fig. 3A

# Fig. 3B

# Fig. 3C

$\frac{1}{Td}$

D

2

*Fig. 4A*

$B_3$  $B_2$  $B_1$

$W_1$

$W_5$  $W_4$  $W_3$  $W_2$

$E$

$A_2$  $A_1$

*Fig. 4 B*

1

2

A  A

E  E  E  E

D  D  D  D

*Fig. 4C*

EN

EN

$T_d$

t

B

C

# *Fig. 5A*

# *Fig. 5B*

# Fig. 6

*Fig. 7*

*Fig. 8*

# Fig. 9A

# Fig. 9B

*Fig. 10 A*

*Fig. 10 B*

*Fig. 10 C*

*Fig. 10 D*